# EUROPEAN PATENT APPLICATION

(11) **EP 2 278 864 A1**
(43) Date of publication of application: **26.01.2011**
(21) Application number: 09735831.1
(22) Date of filing: 24.04.2009
(51) Int. Cl.: H05K 3/34, H05K 1/02, H05K 1/18, H05K 3/28

(54) **SUBSTRATE, STRUCTURE FOR MOUNTING SURFACE MOUNTING COMPONENT, AND ELECTRONIC DEVICE**

(30) Priority: 24.04.2008 JP 2008113830
(71) Applicant: NEC Corporation, Minato-ku Tokyo 108-8001 (JP)
(72) Inventor: YUGAMI, Kazuyuki, Tokyo 108-8001 (JP); FURUSAWA, Koji, Tokyo 108-8001 (JP)
(74) Representative: Vossius & Partner
(86) International application number: PCT/JP2009/058131
(87) International publication number: WO 2009/131204

(57) **Abstract**

To solve a problem in which when a surface mounting component to be soldered at a vicinity of an end portion is mounted by soldering, warpage may occurs in a board or the surface mounting component and a distance between the terminal of the board and the terminal of the surface mounting component increases and whereby a connection failure occurs with respect to a connection using the solder. For this purpose, in a mounting structure of the surface mounting component that is configured by connecting the surface mounting component to the board at the vicinity of the end portion by soldering, a concave portion is formed between joint portions for the soldering in a range in which the surface mounting component of the board is mounted. This concave portion is configured so that an influence of deformation due to the warpage of the board or/and the surface mounting component can be reduced by the concave portion.

## Description

### [Technical field]

The present invention relates to a board configured so as to mount a surface mounting component at a vicinity of an end portion by soldering, a mounting structure of a surface mounting component, and an electronic device.

### [Background art]

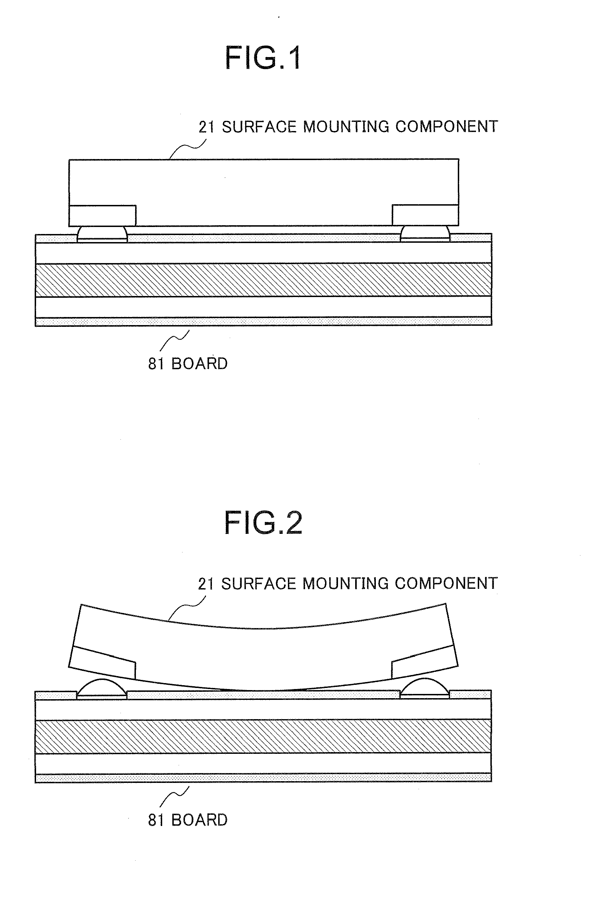

Generally, the surface mounting component is mounted on the board and when component warpage or warpage of the board does not occur by reflow or the like, a land of the board is connected to a land of a component side by a solder as shown in Fig. 1.

As a related technology of the present invention, there is a technology in which in a step for mounting a semiconductor device on the board via a solder ball, a height of the solder ball at the end area is made higher than the central area and which prevents a connection failure due to the warpage of the surface mounting component (refer to, for example, patent document 1).

As a related technology of the present invention, there is a technology in which a slit or a hole parallel to a terminal of a chip part is formed in a periphery of a mounting portion of the chip part on the board and which reduces a fatigue failure caused by the difference in the coefficient of thermal expansion of the chip part and the board (refer to, for example, patent document 2).

As a related technology of the present invention, there is a technology which prevents the formation of the independent solder ball on a component side surface which proceeds when the flux of the solder exudes between a bottom plate of the component and a resist surface of the board at the time of soldering.. In a resist structure for this purpose, the resist is not applied to a board portion under the component having no board conductor portion between the lands for the soldering (refer to, for example, patent document 3).

### [Prior art document]

### [Patent document]

[Patent document 1] Japanese Patent Application Laid-Open No. 2007-67129
[Patent document 2] Japanese Utility Model Application Laid-Open No. H06-13177
[Patent document 3] Japanese Utility Model Applications Laid-Open No. H07-10976

### [Summary of the invention]

### [Problems to be solved by the invention]

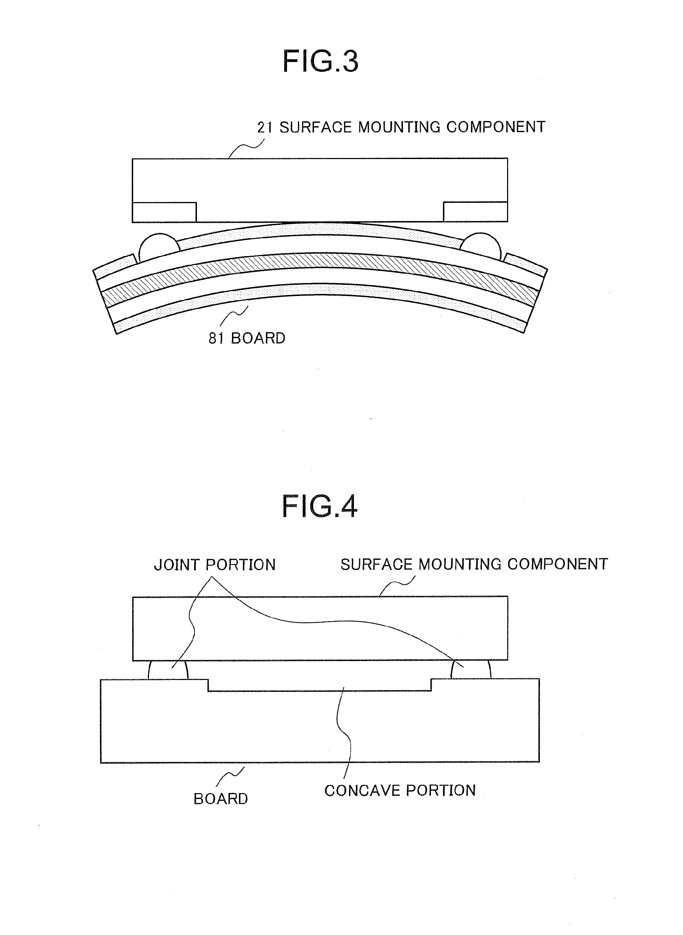

However, when the warpage occurs in the surface mounting component or the board in a reflow step or the like, as shown in Fig. 2 and Fig. 3, the land of a board 81 is separated from the land of a surface mounting component 21, and whereby a connection failure may occur with respect to the connection using the solder.

The above-mentioned technology described in the patent document 1 is intended to be applied to the surface mounting component with terminals arranged in a grid pattern such as a BGA (Ball Grid Array) and it can not be applied to the surface mounting component mounted at the vicinity of the end portion by the soldering, such as the surface mounting component of a QFN (Quad Flat Non-leaded Package).

In the above-mentioned technology described in the patent document 2, the hole or the slit that penetrates the board is formed in a periphery of the chip part in order to reduce a mechanical stress caused by the difference in the coefficient of thermal expansion of the chip part and the board. However, it is not taken into consideration that an influence of deformation due to the warpage of the board or the surface mounting component is reduced by a concave portion.

The above-mentioned technology described in the patent document 3 is intended to solve a problem of which the flux of the solder is sucked out between the bottom plate of the component and the resist surface of the board by capillarity by devising the resist application structure. However, it is not taken into consideration that the influence of deformation due to the warpage of the board or the surface mounting component is reduced.

The present invention is made in consideration of such situation. The object of the present invention is to provide a board of which the influence of deformation due to the warpage of the board or the surface mounting component can be reduced even when the surface mounting component to be soldered is mounted at the vicinity of the end portion by the soldering, a mounting structure of a surface mounting component, and an electronic device.

### [Means for solving the problems]

In order to achieve the object, a board according to the present invention that is a board configured so as to mount a surface mounting component at a vicinity of an end portion by soldering is characterized in that a concave portion is formed between joint portions for the above-mentioned soldering in a range in which the above-mentioned surface mounting component is mounted, and the board is configured so that an influence of deformation due to the warpage of the above-mentioned board or/and the above-mentioned surface mounting component can be reduced by the concave portion.

A mounting structure of a surface mounting component according to the present invention that is a mounting structure of a surface mounting component configured by connecting the surface mounting component to a board at a vicinity of an end portion by soldering is characterized in that a concave portion is formed between joint portions for the above-mentioned soldering in a range in which the above-mentioned surface mounting component of the above-mentioned board is mounted, and the mounting structure of a surface mounting component is configured so that an influence of deformation due to the warpage of the above-mentioned board or/and the above-mentioned surface mounting component can be reduced by the concave portion.

An electronic device according to the present invention is characterized in that the electronic device is configured by having the above-mentioned mounting structure of the surface mounting component according to the present invention.

### [Effect of the invention]

As described above, by using the present invention, even if the surface mounting component to be soldered is mounted at the vicinity of the end portion by the soldering, the influence of deformation due to the warpage of the board or the surface mounting component can be reduced.

### [Brief description of the drawings]

[Figure. 1] Fig. 1 is a sectional view showing a general mounting structure of a surface mounting component.
[Figure. 2] Fig. 2 is a sectional view showing a case in which warpage occurs in a component in a general mounting structure of a surface mounting component.
[Figure. 3] Fig. 3 is a sectional view showing a case in which warpage occurs in a board in a general mounting structure of a surface mounting component.
[Figure. 4] Fig. 4 is a schematic view showing an exemplary embodiment of the present invention.
[Figure. 5] Fig. 5 is a sectional view showing a mounting structure of a surface mounting component of an exemplary embodiment of the present invention.
[Figure. 6] Fig. 6 is a sectional view showing an example of a structure in a case in which a concave portion is formed by removing a resist just under a surface mounting component.
[Figure. 7] Fig. 7 is a sectional view showing an example of a structure in a case in which a concave portion is formed by removing a copper foil layer just under a surface mounting component.
[Figure. 8] Fig. 8 is a sectional view showing an example of a structure in a case in which a concave portion is formed by removing both a resist and a copper foil layer just under a surface mounting component.
[Figure. 9] Fig. 9 is a sectional view showing a case in which warpage occurs in a component in a mounting structure of a surface mounting component of the exemplary embodiment.
[Figure. 10] Fig. 10 is a sectional view showing a case in which warpage occurs in a board in a mounting structure of a surface mounting component of the exemplary embodiment.
[Figure. 11] Fig. 11 is a sectional view showing a case in which warpage occurs in both a component and a board in a mounting structure of a surface mounting component of the exemplary embodiment.

### [Embodiments]

Next, an exemplary embodiment to which a board, a mounting structure of a surface mounting component, and an electronic device according to the present invention are applied will be described in detail by using the drawings.

First, a summary of the exemplary embodiment will be described.
As shown in Fig. 4, the mounting structure of a surface mounting component of the exemplary embodiment is configured by connecting the surface mounting component to the board at the vicinity of the end portion by soldering. A concave portion is formed between joint portions for soldering in a range in which the surface mounting component is mounted on the board surface.
Whereby, even if deformation due to the warpage occurs in the board or/and the surface mounting component, the deformed portion is hardly brought into contact with the board directly by the concave portion. Therefore, the influence of deformation due to the warpage can be reduced.

Thus, the exemplary embodiment is characterized in that a solder connection failure due to the warpage of the mounting board or the component is reduced and a reliability of the solder connection is improved.

For this purpose, in order to alleviate the influence of the component warpage or the warpage of the board in a reflow step, as an example, the concave portion of which a thickness of the board is partially reduced by applying no resist to only the portion just under the surface mounting component of the mounting board is formed to absorb the protruded portion formed by the warpage. Whereby an increase in distance between a component terminal and a board side land and a stress at the time of the reflow are alleviated.
As another example, the thickness of the board is reduced by removing a GND solid pattern or a wiring pattern of a copper foil layer existing at a portion just under the surface mounting component to form the concave portion, and whereby the similar effect can be obtained.

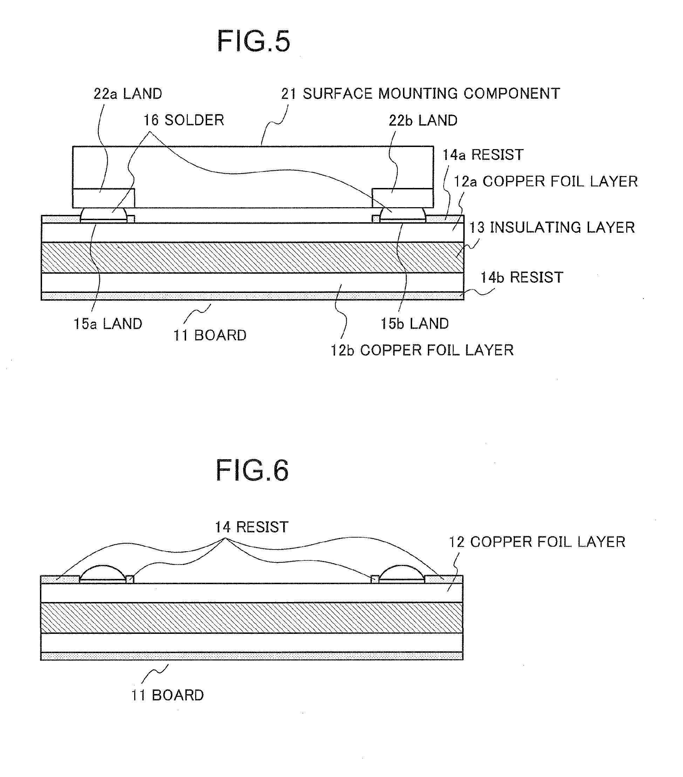

Fig. 5 represents a structure of a board and a surface mounting component in the mounting structure of a surface mounting component of the exemplary embodiment.
A board 11 of the exemplary embodiment is configured by a layered structure comprising copper foil layers 12a and 12b, an insulating layer 13, and resists 14a and 14b. In order to connect a surface mounting component 21 by a solder, lands 15a and 15b are provided on the surface of the board 11 and a solder 16 is formed in a convex shape on each of the surfaces of the lands 15.

In the surface mounting component 21 mounted on the board 11, lands 22a and 22b are provided at an end portion of a lower surface thereof. Whereby, when the surface mounting component 21 is mounted on the board 11 by the reflow, the lands 22a and 22b are connected to the lands 15a and 15b of a board 11 side by the solder 16, respectively.

Here, in a structure in which the concave portion according to the exemplary embodiment is not provided as shown in Fig. 1, as described above as the related technology, when the warpage does not occur in both the board 81 and the surface mounting component 21 at the time of reflow, the land 15 of the board is normally connected to the land 22 of the surface mounting component by the solder 16 as shown in Fig. 1.
However, when the warpage occurs in the surface mounting component as exemplified in Fig. 2 or when the warpage occurs in the board as exemplified in Fig. 3, a distance between the land of the board and the land of the surface mounting component is increased. Consequently, the connection between terminals is not made by the solder 16 and this may result in mounting failure.

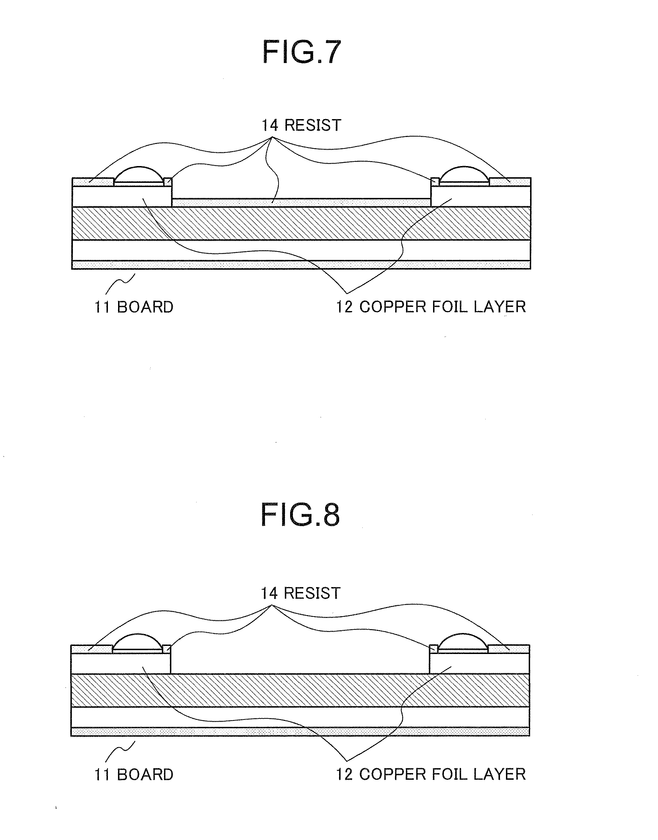

In contrast, in the exemplary embodiment, the resist just under the surface mounting component is removed as shown in Fig. 6, the copper foil layer is removed as shown in Fig. 7, or both the resist and the copper foil layer are removed as shown in Fig. 8 and whereby the concave portion is formed at a portion under the surface mounting component in a board 11 surface. Whereby, even when the warpage occurs in the board 11 or the surface mounting component 21 by the reflow or the like, the lifting of the terminal due to the warpage is reduced and a reliability of the mounting is improved.

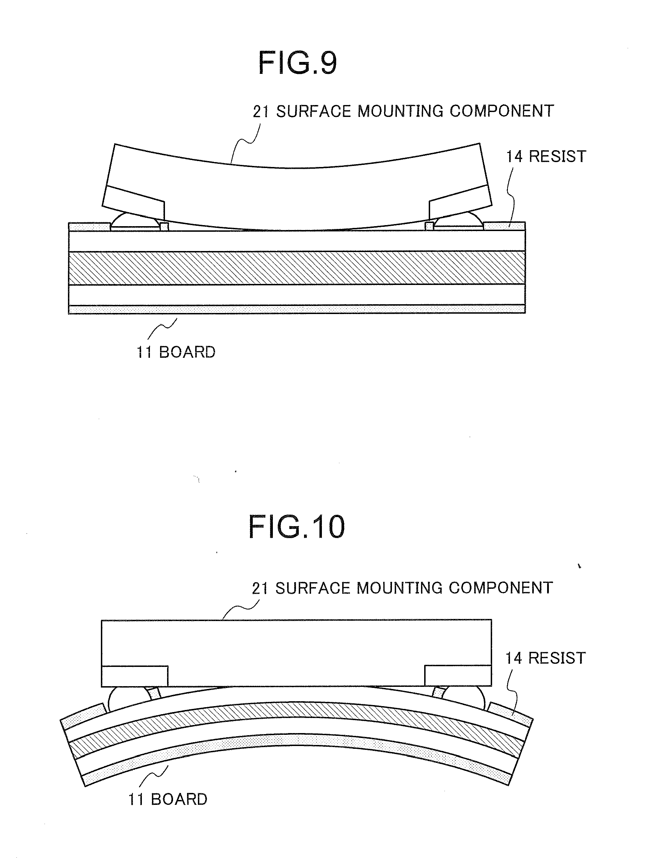

Namely, in the exemplary embodiment, as shown in Fig. 9 and Fig. 10, for example, by using a structure in which the resist on the board 11 surface that exists at a portion just under the surface mounting component is removed, the protruded portion of the board or the component formed by the warpage is absorbed by the concave portion formed by reducing the resist thickness, and whereby the surface mounting component 21 is certainly connected to the board 11 by the solder.

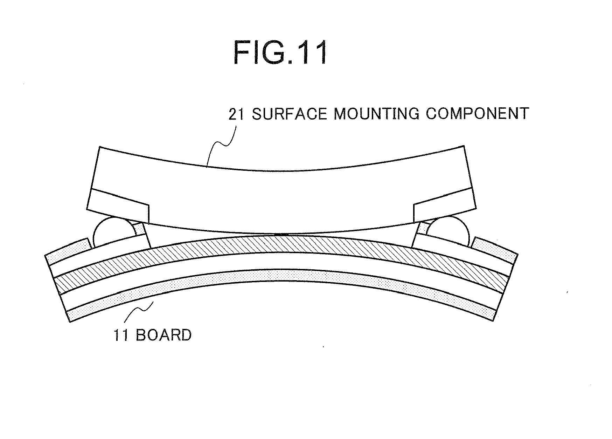

As another exemplary structure, as shown in Fig. 7 and Fig. 8, for example, the concave portion is formed by removing the copper foil layer or by removing both the resist and the copper foil layer, and whereby the similar effect can be obtained.
Thus, when the concave portion is formed by removing both the resist and the copper foil layer, the depth of the concave portion can be made deeper than that in a case in which only the resist is removed. For this reason, for example, as shown in Fig. 11, even when the large warpage occurs in both the board 11 and the surface mounting component 21, the terminals do not separate from each other and the surface mounting component 21 can be certainly connected to the substrate 11 by the solder.

As described above, by using the above-mentioned exemplary embodiment, the following effect can be obtained.
A first effect is an effect in which even when the warpage occurs in the surface mounting component by the reflow, the solder connection failure can be avoided.
Thus, by the exemplary embodiment, a board design method with which the influence of the warpage of the surface mounting component at the time of the reflow can be reduced by partially removing the resist or the copper foil of the board can be provided.

A second effect is an effect in which even when the warpage occurs in the board by the reflow, the solder connection failure can be avoided.
Thus, by the exemplary embodiment, a board design method with which the influence of the warpage of the board at the time of the reflow can be reduced by partially removing the resist or the copper foil of the board can be provided.

As described above, by the above-mentioned exemplary embodiment, the influence of deformation due to the warpage of the surface mounting component or the board can be reduced by the concave portion formed on the board surface, and whereby a lifting of the connection terminal does not occur and the occurrence of the connection failure at a terminal portion can be reduced.

By the above-mentioned electronic device configured so as to have the mounting structure of the surface mounting component according to the exemplary embodiment, even when the warpage occurs in the component or the board by the reflow or the like, the electronic device in which the connection failure at the terminal portion hardly occurs and which has excellent reliability can be obtained.
The electronic device may be an arbitrary electronic device if it has the surface mounting component.

Further, each exemplary embodiment mentioned above is a preferred embodiment of the present invention. The present invention is not limited to this and can be carried out with various modifications based on the technical idea of the present invention.
For example, in the exemplary embodiment mentioned above, it has been explained that the solder 16 is formed in a convex shape on the surface of the land 15 on the board 11. However, a structure is not limited to this if the land 22 of the surface mounting component 21 can be connected to the land 15 on the board 11 by the solder. An arrangement position of a solder portion as the joint portion for soldering may be arbitrary. For example, the solder portion having a convex shape may be configured so that it is formed on the surface of the land 15 on the board 11, it is formed on the surface of the land 22 on the surface mounting component, or it is formed on both the surfaces.

In the exemplary embodiment mentioned above, it has been explained that the concave portion is formed on the board 11 surface by removing the resist under the surface mounting component as shown in Fig. 6, removing the copper foil layer as shown in Fig. 7, or removing both the resist and the copper foil layer as shown in Fig. 8. However, the structure is not limited to this if the concave portion can be formed between the lands in a range in which the surface mounting component on the board surface is mounted and a method for forming the concave portion is arbitrary. For example, a structure in which the concave portion is formed by performing scraping to a predetermined depth between the lands on the board surface may be used.

This application claims priority based on the Japanese Patent Application No. 2008-113830 filed on April 24th, 2008 and the disclosure of which is hereby incorporated by reference in its entirety. [Description of symbol]

- 11: board
- 12: copper foil layer
- 13: insulating layer
- 14: resist
- 15: land
- 16: solder
- 21: surface mounting component
- 22: land

## Claims

1. A board configured so as to mount a surface mounting component at a vicinity of an end portion by soldering **characterized in that**
a concave portion is formed between joint portions for the soldering in a range in which the surface mounting component is mounted, and the board is configured so that an influence of deformation due to warpage of the board or/and the surface mounting component can be reduced by the concave portion.

2. The board according to claim 1 **characterized in that** the concave portion is formed by removing at least a resist in the board.

3. The board according to claim 2 **characterized in that** the concave portion is formed by further removing at least a copper foil layer in the board.

4. The board according to any one of claims 1 to 3 **characterized in that** the surface mounting component is mounted by a reflow.

5. The board according to any one of claims 1 to 4 **characterized in that** the joint portion is formed so that a solder portion for mounting the surface mounting component by the soldering is formed in a convex shape on the surface of the joint portion.

6. A mounting structure of a surface mounting component that is configured by connecting the surface mounting component to a board at a vicinity of an end portion by soldering **characterized in that**
a concave portion is formed between joint portions for the soldering in a range in which the surface mounting component of the board is mounted and the mounting structure of a surface mounting component is configured so that an influence of deformation due to warpage of the board or/and the surface mounting component can be reduced by the concave portion.

7. The mounting structure of the surface mounting component according to claim 6 **characterized in that** the concave portion is formed by removing at least a resist in the board.

8. The mounting structure of the surface mounting component according to claim 7 **characterized in that** the concave portion is formed by further removing at least a copper foil layer in the board.

9. The mounting structure of the surface mounting component according to any one of claims 6 to 8 **characterized in that** the surface mounting component is mounted on the board by a reflow.

10. The mounting structure of the surface mounting component according to any one of claims 6 to 9 **characterized in that** the surface mounting component is mounted by melting a solder portion formed in a convex shape on the board surface as the joint portion.

11. An electronic device **characterized by** being configured so as to have the mounting structure of the surface mounting component according to any one of claims 6 to 10.
